# EUROPEAN PATENT SPECIFICATION

(11) **EP 4 439 656 B1**
(45) Date of publication and mention of the grant of the patent: **04.03.2026**
(21) Application number: 24166301.2
(22) Date of filing: 26.03.2024
(51) Int. Cl.: H01L 23/373, H01L 23/42, H01L 23/31, H01L 23/367

(54) **SEMICONDUCTOR DEVICE**
HALBLEITERANORDNUNG
DISPOSITIF SEMI-CONDUCTEUR

(30) Priority: 31.03.2023 TW 112112626
(43) Date of publication of application: 02.10.2024
(60) Divisional application: 25172736.8
(73) Proprietor: Winchain Material Technology Co., Ltd., Kaohsiung City 833169 (TW)
(72) Inventor: LIN, Chiu-Lang, 83067 Kaohsiung City (TW)
(74) Representative: Reddie & Grose LLP

(56) References cited:
- EP-A1- 4 057 337
- US-A- 5 931 222

## Description

The disclosure relates to a semiconductor device, and more particularly to a semiconductor device that utilizes a liquid metal layer as a heat dissipation interface.

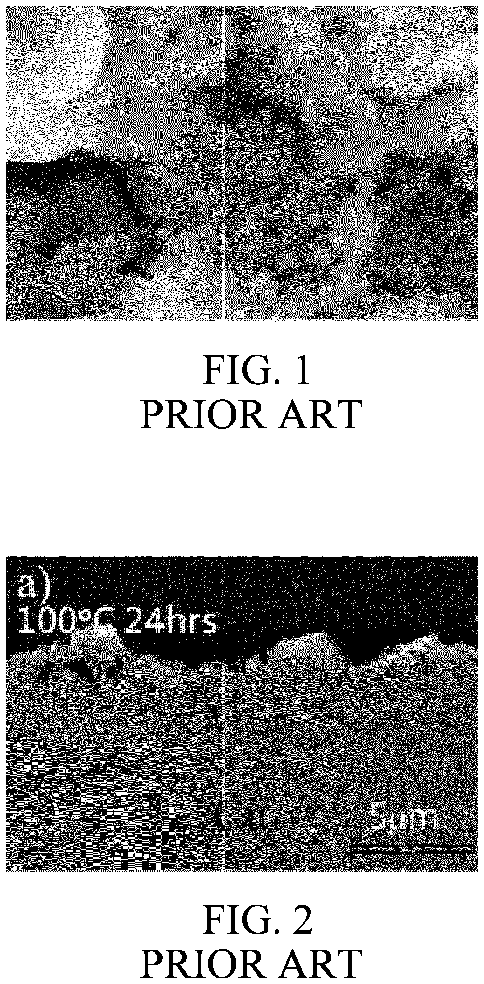

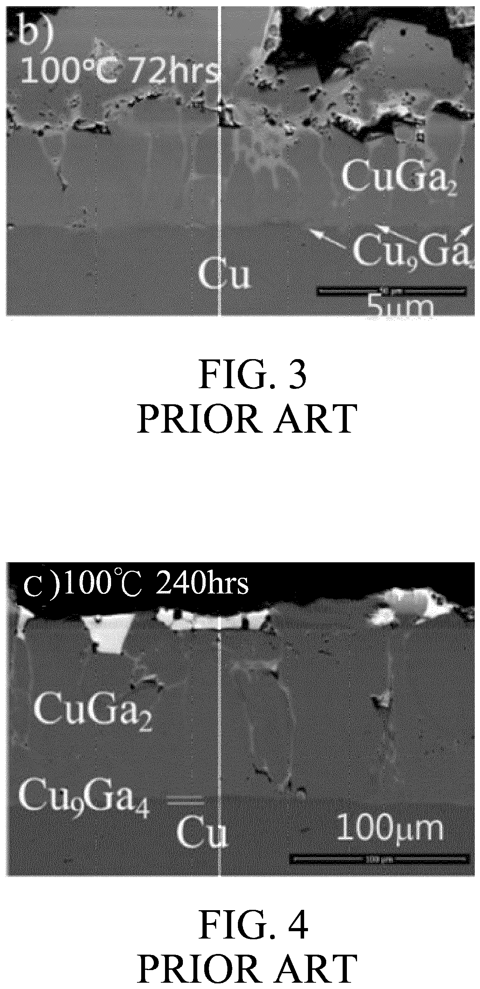

A liquid metal is a metal alloy with a low melting point that remains in a liquid state at room temperature. For example, the liquid metal may be a gallium-indium-tin alloy, a gallium-indium alloy, an indium-bismuth-tin alloy, or an indium-bismuth-zinc alloy. Since the liquid metal has a stable property on thermal conductivity and electrical conductivity, and its thermal conductivity and specific heat capacity are significantly higher than those of a conventional silicone thermal grease, the liquid metal is currently utilized as a thermal interface material between a heat source and a heat dissipation module. However, a conventional heat dissipation module usually employs copper or aluminum as its primary materials. Aluminum is likely to interact with the liquid metal and is prone to rapid corrosion caused by gallium metal in the liquid metal, which results in a degradation in thermal conductivity performance of the liquid metal, and damage to the conventional heat dissipation module. Moreover, copper has a much stable electron configuration due to 10 electrons in its 3d orbital (3d¹⁰), so that, compared to aluminum, copper is less susceptible to rapid corrosion caused by gallium metal. Nevertheless, referring to FIG. 1, empirical observations reveal that after a period of time and under an elevated temperature, copper and gallium may still cooperatively form needle-like copper-gallium intermetallic compounds (e.g., CuGa₂ and Cu₉Ga₄) at an interface therebetween, which is also known as liquid metal dry-out. Referring to FIGS. 2 to 4, such intermetallic compounds gradually accumulate and thicken under long term use, and eventually cause the liquid metal to lose its thermal conductivity and electrical conductivity. In addition, when the liquid metal spills over and comes into contact with electronic components or a substrate, it poses a risk of short circuit damage.

EP 4057337 A1 discloses an electronic device which includes a heat-generating structure and a heat dissipation structure. The heat-generating structure includes a substrate, an electronic component disposed on the substrate, and at least one electronic element disposed on the substrate and spaced apart from the electronic component. The heat dissipation structure includes a heat dissipation body, an anti-corrosion layer formed on the heat dissipation body, a liquid metal layer disposed between the electronic component and the heat dissipation body, a blocking member disposed between the substrate and the anti-corrosion layer, a fixing adhesive located between the electronic component and the blocking member, an insulation layer disposed between the substrate and the anti-corrosion layer, and a cushioning adhesive disposed between the blocking member and the anti-corrosion layer.

In view of the above, there is still a need to improve a semiconductor device that uses a liquid metal layer as a heat dissipation interface in the market.

Therefore, an object of the disclosure is to provide a semiconductor device that can alleviate at least one of the drawbacks of the prior art.

According to an aspect of the disclosure, there is provided a semiconductor device according to claim 1.

Other features and advantages of the disclosure will become apparent in the following detailed description of the embodiment(s) with reference to the accompanying drawings. It is noted that various features may not be drawn to scale.
FIG. 1 is an image illustrating formation of needle-like copper-gallium intermetallic compounds.
FIGS. 2 to 4 are images illustrating accumulation of the needle-like copper-gallium intermetallic compounds.
FIG. 5 is a schematic sectional view illustrating a first embodiment of a semiconductor device according to the present disclosure.
FIG. 6 is a schematic top view of the first embodiment in which a heat dissipation cover is detached to show an interior arrangement of the first embodiment.
FIG. 7 is a schematic sectional view illustrating a second embodiment of a semiconductor device according to the present disclosure.
FIG. 8 is a schematic sectional view illustrating a third embodiment of a semiconductor device according to the present disclosure.
FIG. 9 is a schematic sectional view illustrating a fourth embodiment of a semiconductor device according to the present disclosure.
FIG. 10 is a schematic sectional view illustrating a variation of the fourth embodiment.
FIG. 11 is a schematic sectional view illustrating a fifth embodiment of a semiconductor device according to the present disclosure.
FIG. 12 is a schematic sectional view illustrating a variation of the fifth embodiment.
FIG. 13 is a schematic sectional view illustrating a sixth embodiment of a semiconductor device according to the present disclosure.
FIG. 14 is a schematic sectional view illustrating a variation of the sixth embodiment.

Before the disclosure is described in greater detail, it should be noted that where considered appropriate, reference numerals or terminal portions of reference numerals have been repeated among the figures to indicate corresponding or analogous elements, which may optionally have similar characteristics.

It should be noted herein that for clarity of description, spatially relative terms such as "top," "bottom," "upper," "lower," "on," "above," "under," "over," "downwardly," "upwardly" and the like may be used throughout the disclosure while making reference to the features as illustrated in the drawings. The features may be oriented differently (e.g., rotated 90 degrees or at other orientations) and the spatially relative terms used herein may be interpreted accordingly.

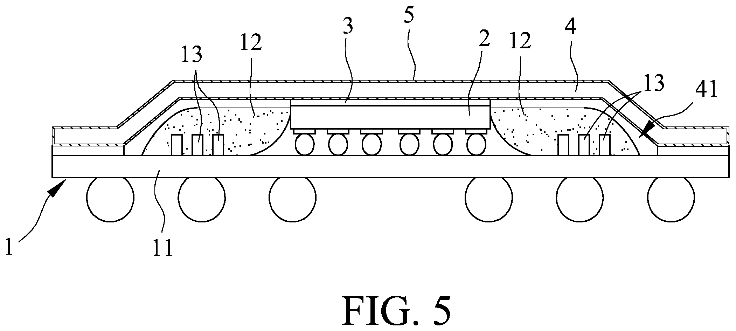

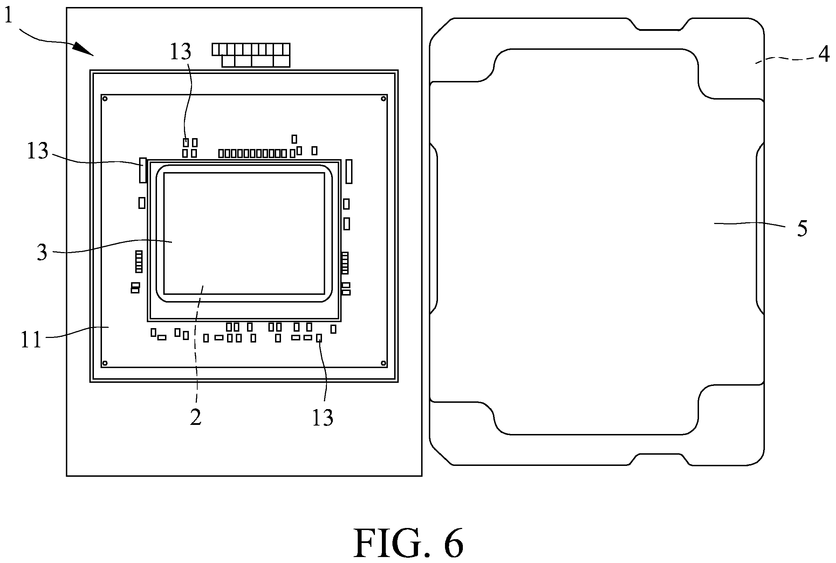

Referring to FIGS. 5 and 6, a first embodiment of a semiconductor device according to the present disclosure includes a substrate unit 1, a chip 2 that is disposed on the substrate unit 1, a liquid metal layer 3 that is coated on a top surface of the chip 2, a heat dissipation cover 4 that is disposed on and covers the substrate unit 1 and the chip 2, and a corrosion protection layer 5 that is coated or plated on the heat dissipation cover 4 to encapsulate the heat dissipation cover 4 and that comes into contact with the liquid metal layer 3.

In the first embodiment, the substrate unit 1 includes a substrate 11 on which the chip 2 is disposed, a plurality of electronic components 13 that are disposed on the substrate 11, and an insulating layer 12 that is coated and disposed on the substrate 11 and encapsulates the electronic components 13. The insulating layer 12 is made of a glue material or a polymeric material, and a top surface of the insulating layer 12 does not abut against the corrosion protection layer 5 (see FIG. 5). By virtue of the insulating layer 12, the plurality of electronic components 13 are effectively encapsulated and protected, so that the plurality of electronic components 13 do not come into contact with overflow of the liquid metal layer 3. In some embodiments, the liquid metal layer 3 may be a gallium-containing layer. The gallium-containing layer may be a gallium-indium-tin alloy layer or a gallium-indium alloy layer, etc. In some embodiments, the heat dissipation cover 4 may be an integrated heat spreader (IHS), and may be made of an isotropic material (e.g., metal) or an anisotropic material (e.g., graphite or ceramic). The metal of the heat dissipation cover 4 may be aluminum. The heat dissipation cover 4 and the substrate 11 of the substrate unit 1 cooperatively define an inner space 41 for accommodating the chip 2 and the liquid metal layer 3.

In the first embodiment, a material of the corrosion protection layer 5 may include nickel metal, a nickel-palladium-gold alloy, gold metal, silver metal, a graphite material, or a ceramic material. In an embodiment, the material of the corrosion protection layer 5 is selected from the group consisting of nickel metal, a nickel-palladium-gold alloy, gold metal, silver metal, a graphite material, and a ceramic material. The material of the corrosion protection layer 5 may be different from that of the heat dissipation cover 4. The corrosion protection layer 5 is able to prevent direct contact between the liquid metal layer 3 and the heat dissipation cover 4, so as to prevent corrosion of the heat dissipation cover 4 influenced by the liquid metal layer 3, and to prevent formation of intermetallic compounds between the liquid metal layer 3 and the heat dissipation cover 4, thereby effectively ensuring stability on thermal conductivity and electrical conductivity of the liquid metal layer 3. Meanwhile, the liquid metal layer 3 and the heat dissipation cover 4 may provide a better heat dissipation effect, so that the semiconductor device has a better working efficiency. It should be noted that the heat dissipation cover 4 may be made of an anticorrosive material, and may be integrally formed with the corrosion protection layer 5. In addition, the heat dissipation cover 4 may be designed to have heat dissipating fins, but other designs may also be suitable for this disclosure.

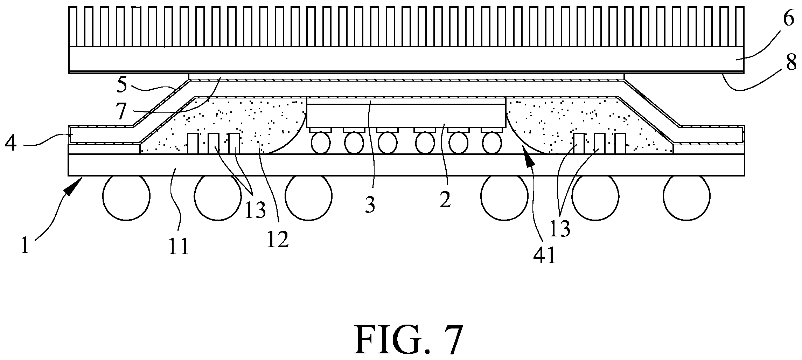

Referring to FIG. 7, a second embodiment of the semiconductor device according to the present disclosure is generally similar to the first embodiment, except that in the second embodiment, the semiconductor device further includes a heat dissipation module 6 that is disposed on and covers the heat dissipation cover 4, a heat conductive layer 7 that is disposed between the heat dissipation cover 4 and the heat dissipation module 6 and comes into contact with the corrosion protection layer 5, and an anti-corrosion layer 8 that is coated or plated on the heat dissipation module 6 and comes into contact with the heat conductive layer 7. In the second embodiment, a material of the heat dissipation module 6 may include copper, aluminum, a metal alloy, or combinations thereof. In an embodiment, the material of the heat dissipation module 6 is selected from the group consisting of copper, aluminum, a metal alloy, and combinations thereof. A material of the heat conductive layer 7 may be a liquid metal. A material of the anti-corrosion layer 8 may include nickel metal, a nickel-palladium-gold alloy, gold metal, silver metal, a graphite material, or a ceramic material. In an embodiment, the material of the anti-corrosion layer 8 is selected from the group consisting of nickel metal, a nickel-palladium-gold alloy, gold metal, silver metal, a graphite material, and a ceramic material. In addition, the insulating layer 12 abuts against the corrosion protection layer 5. The second embodiment utilizes both the corrosion protection layer 5 and the anti-corrosion layer 8 to prevent the heat conductive layer 7 from directly contacting the heat dissipation cover 4 and the heat dissipation module 6. It should be noted that the first embodiment may adopt the design in which the insulating layer 12 abuts against the corrosion protection layer 5, and the second embodiment may adopt the design in which the insulating layer 12 does not abut against the corrosion protection layer 5.

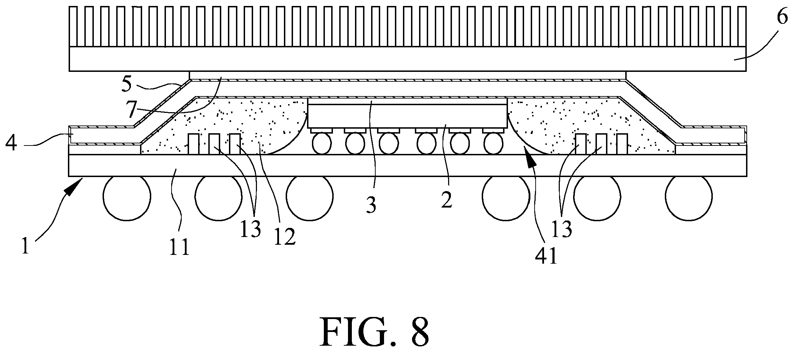

Referring to FIG. 8, a third embodiment of the semiconductor device according to the present disclosure is generally similar to the second embodiment, except that in the third embodiment, the semiconductor device does not include the anti-corrosion layer 8 (see FIG. 7), and the material of the heat conductive layer 7 may be a thermal grease, a thermal pad, a phase change material made of silicone oil or non-silicone oil, or a solder.

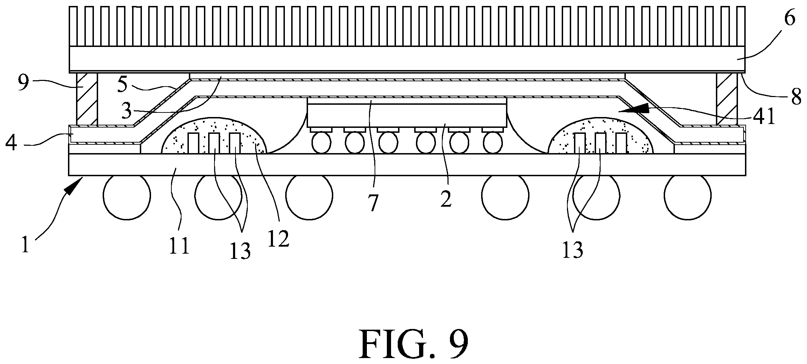

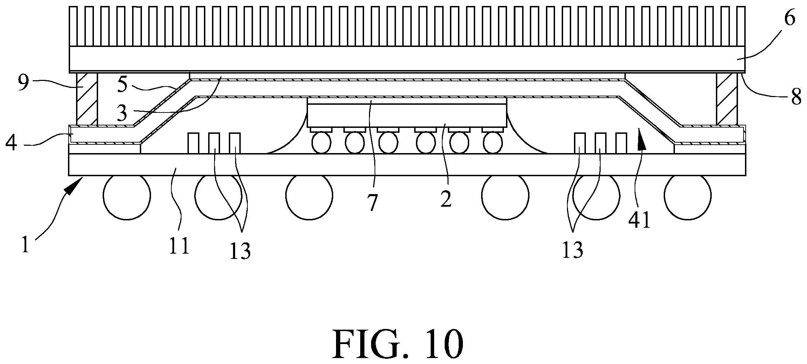

Referring to FIG. 9, a fourth embodiment of the semiconductor device according to the present disclosure is generally similar to the second embodiment, except that in the fourth embodiment, the material of the heat conductive layer 7 may be the liquid metal, the thermal grease, the thermal pad, the phase change material made of silicone oil or non-silicone oil, or the solder, and the locations of the heat conductive layer 7 and the liquid metal layer 3 are interchanged. Moreover, the semiconductor device further includes a blocking member 9 that is disposed under the anti-corrosion layer 8, that is disposed between the corrosion protection layer 5 and the anti-corrosion layer 8 and that surrounds the liquid metal layer 3. A bottom surface of the blocking member 9 comes into contact with the corrosion protection layer 5, and a top surface of the blocking member 9 comes into contact with the anti-corrosion layer 8. The blocking member 9 serves to prevent a spillover of the liquid metal layer 3 from reaching a mainboard (not shown), which may cause a short circuit and corrosion of metal components of the mainboard. In the fourth embodiment, the blocking member 9 is made of a polymeric material. In addition, when the material of the heat conductive layer 7 is the liquid metal, the insulating layer 12 encapsulates the plurality of electronic components 13. In this embodiment, the insulating layer 12 may not contact the corrosion protection layer 5 (see FIG. 9), or may abut against the corrosion protection layer 5. When the material of the heat conductive layer 7 is the thermal grease, the thermal pad, the phase change material made of silicone oil or non-silicone oil, or the solder, the insulating layer 12 of the semiconductor device may be dispensed with (see FIG. 10, a variation of the fourth embodiment).

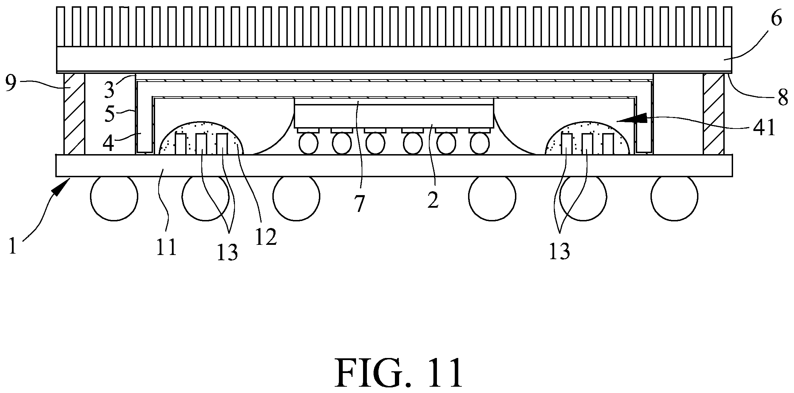

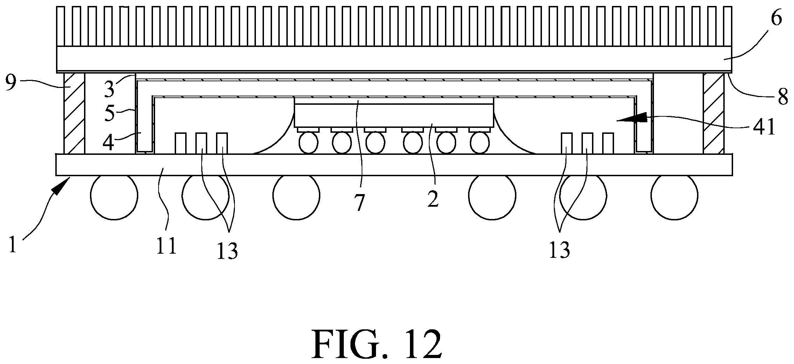

Referring to FIG. 11, a fifth embodiment of the semiconductor device according to the present disclosure is generally similar to the fourth embodiment, except that in the fifth embodiment, the blocking member 9 is disposed outside the heat dissipation cover 4 and the corrosion protection layer 5, and surrounds the heat dissipation cover 4 and the corrosion protection layer 5. In addition, the substrate unit 1 is not completely covered by the heat dissipation cover 4 so that a part of the substrate 11 is exposed from the heat dissipation cover 4, and the blocking member 9 is disposed between and is in contact with the anti-corrosion layer 8 and the substrate 11. When the material of the heat conductive layer 7 is the liquid metal, the insulating layer 12 is disposed on the substrate 11, and encapsulates the plurality of electronic components 13. In this embodiment, the insulating layer 12 may not contact the corrosion protection layer 5 (see FIG. 11), or may abut against the corrosion protection layer 5. When the material of the heat conductive layer 7 is the thermal grease, the thermal pad, the phase change material made of silicone oil or non-silicone oil, or the solder, the insulating layer 12 of the semiconductor device may be dispensed with (see FIG. 12, a variation of the fifth embodiment).

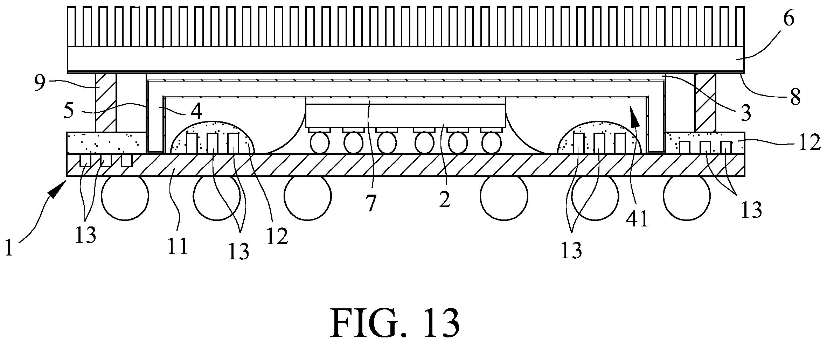

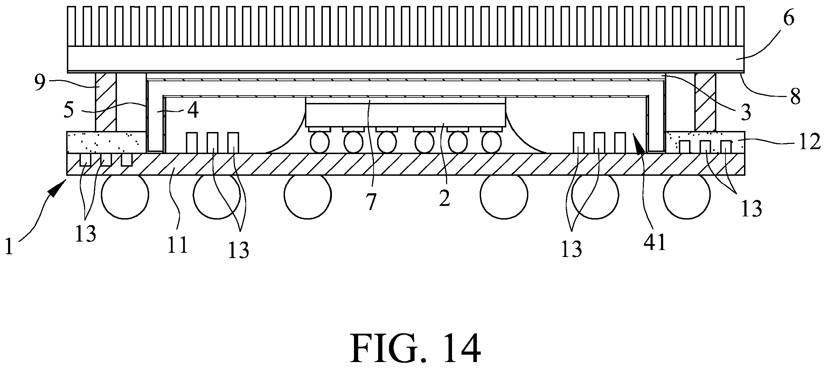

Referring to FIG. 13, a sixth embodiment of the semiconductor device according to the present disclosure is generally similar to the fifth embodiment, except that in the sixth embodiment, some of the electronic components 13 are located in the inner space 41 defined by the heat dissipation cover 4 and the substrate 11, and some of the electronic components 13 are located outside the heat dissipation cover 4 (e.g., located at the part of the substrate 11 that is exposed from the heat dissipation cover 4). The electronic components 13 may be disposed on the substrate 11 or may be embedded within the substrate 11. The insulating layer 12 may be disposed on the substrate 11 at a location where the electronic components 13 are disposed. When the electronic components 13 are disposed on the substrate 11, the insulating layer 12 may encapsulate the electronic components 13. When the electronic components 13 are embedded within the substrate 11, the insulating layer 12 may be overlaid on a top of the electronic components 13, and further encapsulates the electronic components 13 within the substrate 11. In this embodiment, the electronic components 13 located in the inner space 41 are disposed on (i.e., protrude from) the substrate 11, and for the electronic components 13 located outside the heat dissipation cover 4, some of them are disposed on (i.e., protrude from) the substrate 11, and some of them are embedded within the substrate 11. Moreover, a first portion of the insulating layer 12 may encapsulate the electronic components 13 located in the inner space 41, and a second portion of the insulating layer 12 may encapsulate or be overlaid on the electronic components 13 located outside the heat dissipation cover 4 (which depends on the arrangement, i.e., protruding from or embedded within the substrate 11, of the electronic components 13). When the material of the heat conductive layer 7 is the liquid metal, the first portion of the insulating layer 12 is disposed on the substrate 11 and encapsulates the electronic components 13 located in the inner space 41. The first portion of the insulating layer 12 may not contact the corrosion protection layer 5 (see FIG. 13), or a top of the first portion of the insulating layer 12 may abut against the corrosion protection layer 5. When the material of the heat conductive layer 7 is the thermal grease, the thermal pad, the phase change material made of silicone oil or non-silicone oil, or the solder, it may be unnecessary to dispose the first portion of the insulating layer 12 on the electronic components 13 that are located in the inner space 41 (see FIG. 14, a variation of the six embodiment). In addition, in order to prevent any potential leakage of the liquid metal layer 3, the blocking member 9 is disposed between the anti-corrosion layer 8 and the second portion of the insulating layer 12 and surrounds the heat dissipation cover 4 and the corrosion protection layer 5.

In summary, in the semiconductor device according to the present disclosure, by virtue of the corrosion protection layer 5 and the anti-corrosion layer 8, direct contact of the liquid metal layer 3 or the heat conductive layer 7 with the heat dissipation cover 4 and the heat dissipation module 6 can be prevented. In addition to preventing corrosion, the formation of intermetallic compounds that are generated between the liquid metal layer 3 and the heat dissipation cover 4 can also be prevented, thus effectively maintaining the stability of the liquid metal layer 3. Furthermore, the insulating layer 12 may encapsulate the electronic components 13, thereby effectively preventing such electronic components 13 from coming into contact with any spilled liquid metal layer 3.

In the description above, for the purposes of explanation, numerous specific details have been set forth in order to provide a thorough understanding of the embodiment(s). It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects; such does not mean that every one of these features needs to be practiced with the presence of all the other features. In other words, in any described embodiment, when implementation of one or more features or specific details does not affect implementation of another one or more features or specific details, said one or more features may be singled out and practiced alone without said another one or more features or specific details. It should be further noted that one or more features or specific details from one embodiment may be practiced together with one or more features or specific details from another embodiment, where appropriate, in the practice of the disclosure.

## Claims

1. A semiconductor device, comprising:
a substrate unit (1) including a substrate (11), a plurality of electronic components (13) disposed on said substrate (11), and an insulating layer (12) disposed on said substrate (11) and encapsulating said electronic components (13);
a chip (2) disposed on said substrate (11);
a liquid metal layer (3) coated on said chip (2);
a heat dissipation cover (4) disposed on and covering said substrate (11); and
a corrosion protection layer (5) disposed on said heat dissipation cover (4) to encapsulate said heat dissipation cover (4) and coming into contact with said liquid metal layer (3).

2. The semiconductor device as claimed in claim 1, wherein a material of said corrosion protection layer (5) is selected from the group consisting of nickel metal, a nickel-palladium-gold alloy, gold metal, silver metal, a graphite material, and a ceramic material.

3. The semiconductor device as claimed in any one of claims 1 and 2, wherein said heat dissipation cover (4) is made of an isotropic material or an anisotropic material.

4. The semiconductor device as claimed in any one of claims 1 to 3, further comprising
a heat dissipation module (6) disposed on and covering said heat dissipation cover (4),
a heat conductive layer (7) disposed between said heat dissipation cover (4) and said heat dissipation module (6) and coming into contact with said corrosion protection layer (5), and
an anti-corrosion layer (8) disposed on said heat dissipation module (6) and coming into contact with said heat conductive layer (7),
wherein a material of said heat conductive layer (7) is a liquid metal.

5. The semiconductor device as claimed in claim 4, wherein a material of said anti-corrosion layer (8) is selected from the group consisting of nickel metal, a nickel-palladium-gold alloy, gold metal, silver metal, a graphite material, and a ceramic material.

6. The semiconductor device as claimed in claim 4, wherein a material of said heat dissipation module (6) is selected from the group consisting of copper, aluminum, a metal alloy, and combinations thereof.

7. The semiconductor device as claimed in any one of claims 1 to 3, further comprising
a heat dissipation module (6) disposed on and covering said heat dissipation cover (4), and
a heat conductive layer (7) disposed between said heat dissipation cover (4) and said heat dissipation module (6) and coming into contact with said corrosion protection layer (5),
wherein a material of said heat conductive layer (7) is selected from the group consisting of a thermal grease, a thermal pad, a phase change material, and a solder.

8. The semiconductor device as claimed in claim 7, wherein a material of said heat dissipation module (6) is selected from the group consisting of copper, aluminum, a metal alloy, and combinations thereof.

9. The semiconductor device as claimed in any one of claims 1 to 8, wherein said insulating layer (12) is made of a glue material or a polymeric material.

10. The semiconductor device as claimed in any one of claims 1 to 9, wherein said heat dissipation cover (4) is made of an anticorrosive material, and is integrally formed with said corrosion protection layer (5).

## Patentansprüche

1. Halbleiterbauelement, umfassend:
eine Substrateinheit (1) mit einem Substrat (11), einer Mehrzahl von elektronischen Komponenten (13), die auf dem genannten Substrat (11) angeordnet sind, und einer Isolierschicht (12), die auf dem genannten Substrat (11) angeordnet ist und die genannten elektronischen Komponenten (13) umschließt;
einen Chip (2), der auf dem genannten Substrat (11) angeordnet ist;
eine Flüssigmetallschicht (3), mit auf den genannten Chip (2) aufgebracht ist;
eine Wärmeableitungsabdeckung (4), die auf dem genannten Substrat (11) angeordnet ist und dieses abdeckt;
eine Korrosionsschutzschicht (5), die auf der genannten Wärmeableitungsabdeckung (4) angeordnet ist, um die genannte Wärmeableitungsabdeckung (4) zu umschließen, und die mit der genannten Flüssigmetallschicht (3) in Kontakt kommt.

2. Halbleiterbauelement nach Anspruch 1, wobei ein Material der genannten Korrosionsschutzschicht (5) aus der Gruppe bestehend aus Nickelmetall, einer Nickel-Palladium-Gold-Legierung, Goldmetall, Silbermetall, einem Graphitmaterial und einem Keramikmaterial ausgewählt ist.

3. Halbleiterbauelement nach einem der Ansprüche 1 und 2, wobei die genannte Wärmeableitungsabdeckung (4) aus einem isotropen Material oder einem anisotropen Material besteht.

4. Halbleiterbauelement nach einem der Ansprüche 1 bis 3, ferner umfassend
ein Wärmeableitungsmodul (6), das an der genannten Wärmeableitungsabdeckung (4) angeordnet ist und diese abdeckt,
eine wärmeleitende Schicht (7), die zwischen der genannten Wärmeableitungsabdeckung (4) und dem genannten Wärmeableitungsmodul (6) angeordnet ist und mit der genannten Korrosionsschutzschicht (5) in Kontakt kommt, und
eine Anti-Korrosionsschicht (8), die auf dem genannten Wärmeableitungsmodul (6) angeordnet ist und mit der genannten wärmeleitenden Schicht (7) in Kontakt kommt,
wobei ein Material der genannten wärmeleitenden Schicht (7) ein Flüssigmetall ist.

5. Halbleiterbauelement nach Anspruch 4, wobei ein Material der genannten Anti-Korrosionsschicht (8) aus der Gruppe bestehend aus Nickelmetall, einer Nickel-Palladium-Gold-Legierung, Goldmetall, Silbermetall, einem Graphitmaterial und einem Keramikmaterial ausgewählt ist.

6. Halbleiterbauelement nach Anspruch 4, wobei ein Material des genannten Wärmeableitungsmoduls (6) aus der Gruppe bestehend aus Kupfer, Aluminium, einer Metalllegierung und Kombinationen davon ausgewählt ist.

7. Halbleiterbauelement nach einem der Ansprüche 1 bis 3, ferner umfassend
ein Wärmeableitungsmodul (6), das auf der genannten Wärmeableitungsabdeckung (4) angeordnet ist und diese abdeckt, und
eine wärmeleitende Schicht (7), die zwischen der genannten Wärmeableitungsabdeckung (4) und dem genannten Wärmeableitungsmodul (6) angeordnet ist und mit der genannten Korrosionsschutzschicht (5) in Kontakt kommt,
wobei ein Material der genannten wärmeleitenden Schicht (7) aus der Gruppe bestehend aus einer Wärmeleitpaste, einem Wärmeleitpad, einem Phasenwechselmaterial und einem Lot ausgewählt ist.

8. Halbleiterbauelement nach Anspruch 7, wobei ein Material des genannten Wärmeableitungsmoduls (6) aus der Gruppe bestehend aus Kupfer, Aluminium, einer Metalllegierung und Kombinationen davon ausgewählt ist.

9. Halbleiterbauelement nach einem der Ansprüche 1 bis 8, wobei
die genannte Isolierschicht (12) aus einem Klebstoff oder einem Polymermaterial besteht.

10. Halbleiterbauelement nach einem der Ansprüche 1 bis 9, wobei die genannte Wärmeableitungsabdeckung (4) aus einem korrosionsbeständigen Material besteht und einstückig mit der Korrosionsschutzschicht (5) ausgebildet ist.

## Revendications

1. Dispositif semi-conducteur, **caractérisé par** :
une unité de substrat (1) comportant un substrat (11), une pluralité de composants électroniques (13) disposés sur ledit substrat (11), et une couche isolante (12) disposée sur ledit substrat (11) et encapsulant lesdits composants électroniques (13) ;
une puce (2) disposée sur ledit substrat (11) ;
une couche métallique liquide (3) appliquée sur ladite puce (2) ;
un couvercle de dissipation thermique (4) disposé sur ledit substrat (11) et recouvrant ce dernier ; et
une couche de protection contre la corrosion (5) disposée sur ledit couvercle de dissipation thermique (4) pour encapsuler ledit couvercle de dissipation thermique (4) et venir en contact avec ladite couche métallique liquide (3).

2. Dispositif semi-conducteur selon la revendication 1, dans lequel un matériau de ladite couche de protection contre la corrosion (5) est sélectionné dans le groupe constitué par le nickel métallique, un alliage nickel-palladium-or, un matériau d'or, un matériau d'argent, un matériau de graphite et un matériau céramique.

3. Dispositif semi-conducteur selon l'une quelconque des revendications 1 et 2, dans lequel ledit couvercle de dissipation thermique (4) est constitué d'un matériau isotrope ou d'un matériau anisotrope.

4. Dispositif semi-conducteur selon l'une quelconque des revendications 1 à 3, comprenant en outre
un module de dissipation thermique (6) disposé sur ledit couvercle de dissipation thermique (4) et recouvrant celui-ci ,
une couche conductrice de chaleur (7) disposée entre ledit couvercle de dissipation thermique (4) et le module de dissipation thermique (6) et venant en contact avec ladite couche de protection contre la corrosion (5), et
une couche anti-corrosion (8) disposée sur ledit module de dissipation thermique (6) et venant en contact avec ladite couche conductrice de chaleur (7),
dans lequel un matériau de ladite couche conductrice de chaleur (7) est un métal liquide.

5. Dispositif semi-conducteur selon la revendication 4, dans lequel un matériau de ladite couche anticorrosion (8) est sélectionné dans le groupe constitué par le nickel, un alliage nickel-palladium-or, un métal d'or, un métal d'argent, un matériau de graphite et un matériau céramique.

6. Dispositif semi-conducteur selon la revendication 4, dans lequel un matériau du module de dissipation thermique (6) est sélectionné dans le groupe constitué par le cuivre, l'aluminium, un alliage métallique et des combinaisons de ceux-ci.

7. Dispositif semi-conducteur selon l'une quelconque des revendications 1 à 3, comprenant en outre
un module de dissipation thermique (6) disposé sur ledit couvercle de dissipation thermique et recouvrant celui-ci (4), et
une couche conductrice de chaleur (7) disposée entre ledit couvercle de dissipation thermique (4) et le module de dissipation thermique (6) et venant en contact avec ladite couche de protection contre la corrosion (5),
dans lequel un matériau de ladite couche conductrice de chaleur (7) est sélectionné dans le groupe constitué par une graisse thermique, un tampon thermique, un matériau à changement de phase et une soudure.

8. Dispositif semi-conducteur selon la revendication 7, dans lequel un matériau du module de dissipation thermique (6) est sélectionné dans le groupe constitué par le cuivre, l'aluminium, un alliage métallique et des combinaisons de ceux-ci.

9. Dispositif semi-conducteur selon l'une quelconque des revendications 1 à 8, dans lequel ladite couche isolante (12) est constituée d'un matériau de colle ou d'un matériau polymère.

10. Dispositif semi-conducteur selon l'une quelconque des revendications 1 à 9, dans lequel ledit couvercle de dissipation thermique (4) est fabriqué à partir d'un matériau anticorrosif, et fait partie intégrante de ladite couche de protection contre la corrosion (5).
